# EUROPEAN PATENT APPLICATION

(11) **EP 4 513 214 A1**
(43) Date of publication of application: **26.02.2025**
(21) Application number: 23791783.6
(22) Date of filing: 13.04.2023
(51) Int. Cl.: G01R 33/02

(54) **MAGNETISM DETECTION SYSTEM**

(30) Priority: 19.04.2022 JP 2022068655
(71) Applicant: TDK Corporation, Tokyo 103-6128 (JP)
(72) Inventor: YAMAJI, Yuichiro, Tokyo 103-6128 (JP); KASAJIMA, Tamon, Tokyo 103-6128 (JP); LIN, Chengbin, Tokyo 103-6128 (JP)
(74) Representative: Epping - Hermann - Fischer
(86) International application number: PCT/JP2023/015011
(87) International publication number: WO 2023/204135

(57) **Abstract**

To provide a magnetic field detection system capable of achieving wide-range magnetic field measurement while reducing the number of magnetic sensors to be used. A magnetic field detection system 100 includes: a shield box 200 having magnetic shields S1 to S3 surrounding a measurement space 230; a magnetic sensor 40 fixed to the shield box 200 in the measurement space 230; a sample stage 300 inserted at least at a part thereof into the measurement space 230; and drive mechanisms 141 to 143 for varying the relative positional relationship between the sample stage 300 and shield box 200. The relative positional relationship between the sample stage 300 and shield box 200 can thus be varied by the drive mechanisms 141 to 143, thus enabling magnetic field measurement over a wide range by using a single or a small number of magnetic sensors 40.

## Description

### [Technical Field]

The present invention relates to a magnetic field detection system and, more particularly, to a magnetic field detection system utilized as a foreign object detection system.

### [Background Art]

Patent Document 1 discloses a foreign object detection system having a structure in which a plurality of magnetic sensors are arranged in a measurement space surrounded by a magnetic shield. Such a structure of the foreign object detection system described in Patent Document 1 enables wide-range detection of foreign objects.

### [Citation List]

### [Patent Document]

[Patent Document 1] JP 2011-237181A

### [Disclosure of the Invention]

### [Problem to be Solved by the Invention]

However, use of a plurality of magnetic sensors not only increases cost but also deteriorates detection accuracy due to characteristic variations between magnetic sensors.

An object of the present invention is therefore to provide a magnetic field detection system capable of achieving wide-range magnetic field measurement while reducing the number of magnetic sensors to be used.

### [Means for Solving the Problem]

A magnetic field detection system according to the present invention includes: a shield box having a magnetic shield surrounding a measurement space; a magnetic sensor fixed to the shield box in the measurement space; a sample stage inserted at least at a part thereof into the measurement space; and a drive mechanism for varying the relative positional relationship between the sample stage and shield box.

According to the present invention, the relative positional relationship between the sample stage and shield box can be varied by the drive mechanism, thus enabling magnetic field measurement over a wide range by using a single or a small number of magnetic sensors.

In the present invention, the drive mechanism may include a first drive mechanism for varying the relative positional relationship between the sample stage and the shield box in a first direction, a second drive mechanism for varying the relative positional relationship between the sample stage and the shield box in a second direction perpendicular to the first direction, and a third drive mechanism for varying the relative positional relationship between the sample stage and the shield box in a third direction perpendicular to the first and second directions. This allows not only the planar positional relationship between a sample and the magnetic sensor but also the distance therebetween to be varied.

In the present invention, the surface of the sample stage on which a sample is placed may extend in the first and second directions, the first and second drive mechanisms may drive the sample stage, and the third drive mechanism may drive the shield box. This allows the planar positional relationship between a sample and the magnetic sensor to be varied by the first and second drive mechanisms and allows the distance therebetween to be adjusted by the third drive mechanism.

The magnetic field detection system according to the present invention may further include a magnetic field collecting element which is disposed on an element formation surface of the magnetic sensor that extends parallel to the third direction and which is elongated in a direction perpendicular to the element formation surface. This makes it possible to bring a sample closer to the element formation surface of the magnetic sensor.

In the present invention, the magnetic shield may include a cylindrical first magnetic shield that covers the measurement space from both sides in the second direction and both sides in the third direction and a second magnetic shield that covers the measurement space from one side in the first direction, and the sample stage may be inserted into the measurement space from the other side in the first direction. This allows shielding of all the sides (except the insertion side of the measurement space) of the measurement space into which the sample stage is inserted.

In the present invention, the first and second magnetic shields may each have an arc-like shape at least at a part thereof. This can further enhance shield effect.

The magnetic field detection system according to the present invention may further include a sensor holder that holds the magnetic sensor. The first magnetic shield may have a flat part extending in the first and second directions, the shield box may further have a part that covers the inner wall of the flat part of the first magnetic shield from the third direction, and the sensor holder may be fixed to this part of the shield box. This facilitates fixing of the magnetic sensor.

In the present invention, the magnetic shield may further include a third magnetic shield that covers the first magnetic shield from the second and third directions. This can achieve higher shield effect.

### [Advantageous Effects of the Invention]

As described above, according to the present invention, there can be provided a magnetic field detection system capable of achieving wide-range magnetic field measurement while reducing the number of magnetic sensors to be used.

### [Brief Description of the Drawings]

[FIG. 1]

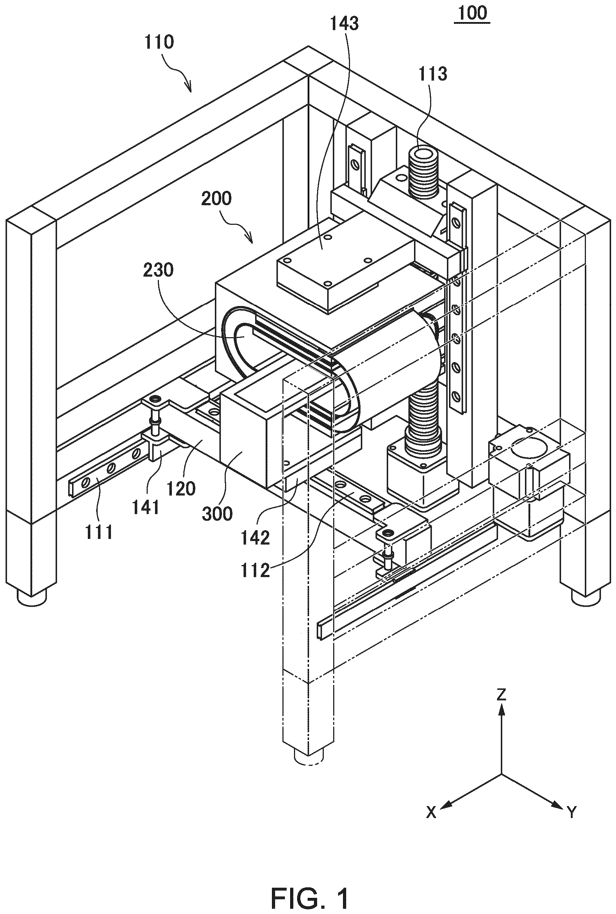

   FIG. 1 is a schematic perspective view illustrating the outer appearance of a magnetic field detection system 100 according to an embodiment of the present invention.
[FIG. 2]

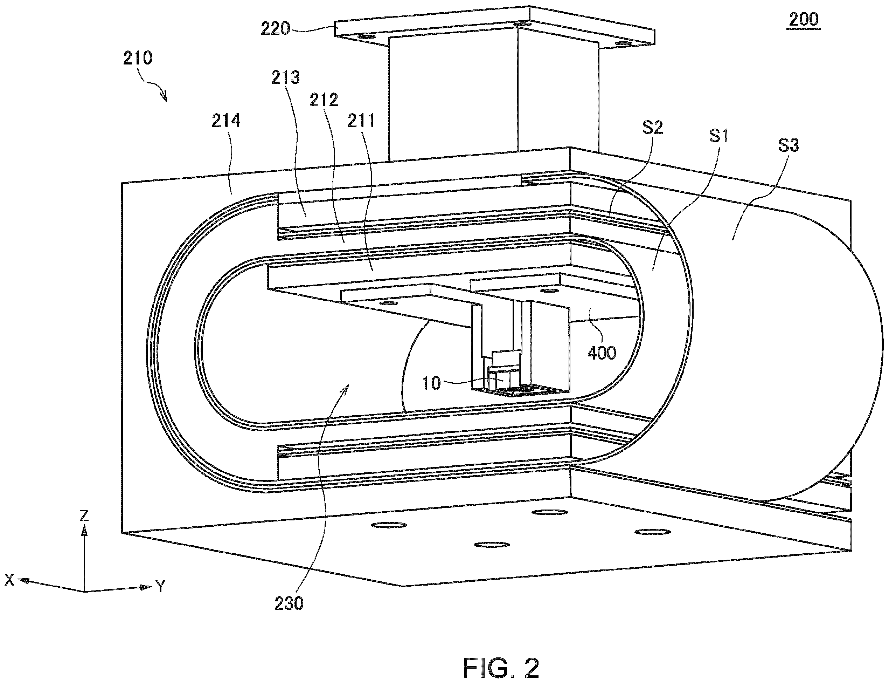

   FIG. 2 is a schematic perspective view for explaining the structure of the shield box 200.
[FIG. 3]

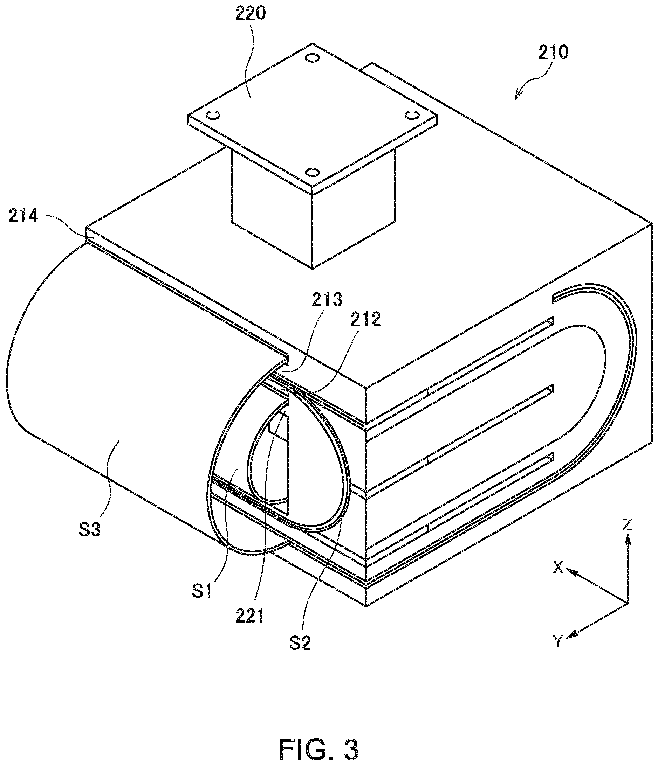

   FIG. 3 is a schematic perspective view for explaining the structure of the shield box 200.
[FIG. 4]

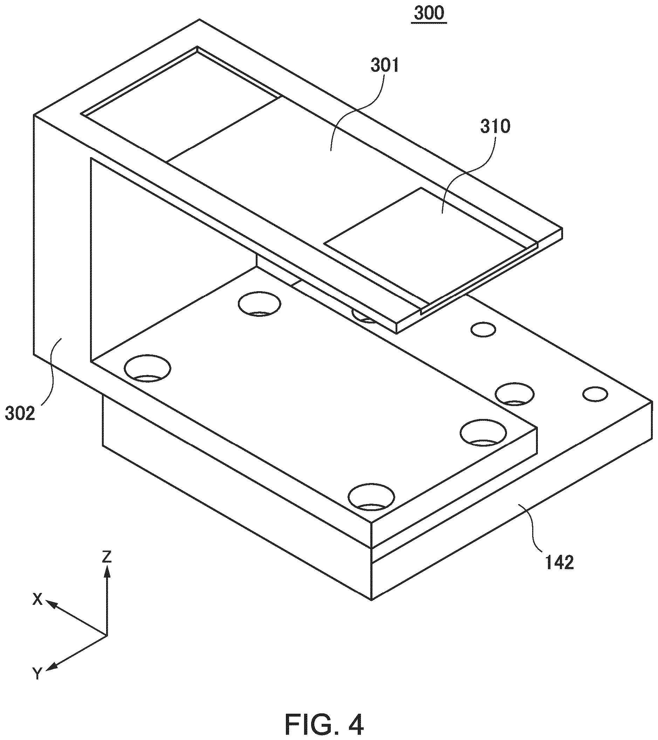

   FIG. 4 is a schematic perspective view for explaining the structure of the sample stage 300.
[FIG. 5]

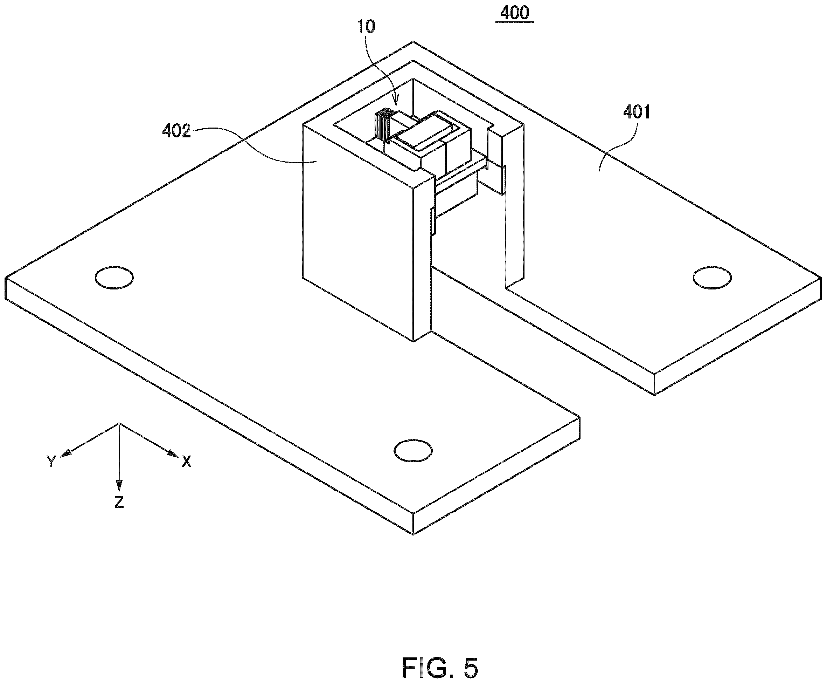

   FIG. 5 is a schematic perspective view for explaining the structure of the sensor holder 400.
[FIG. 6]

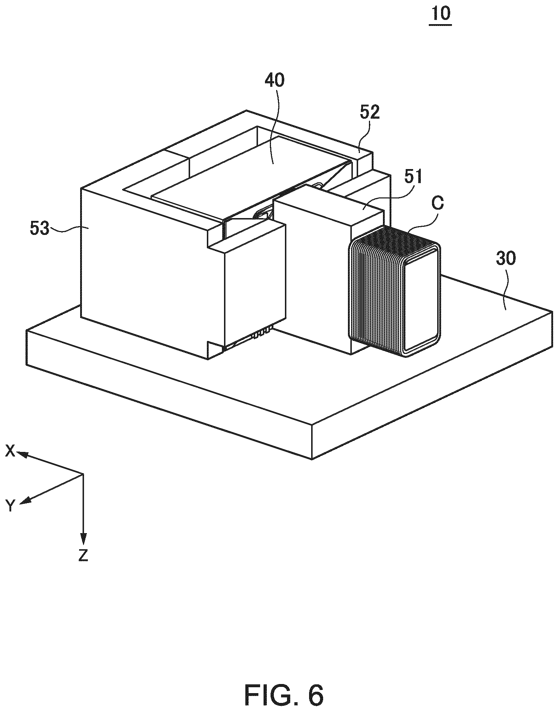

   FIG. 6 is a schematic perspective view for explaining the structure of the sensor main body part 10.
[FIG. 7]

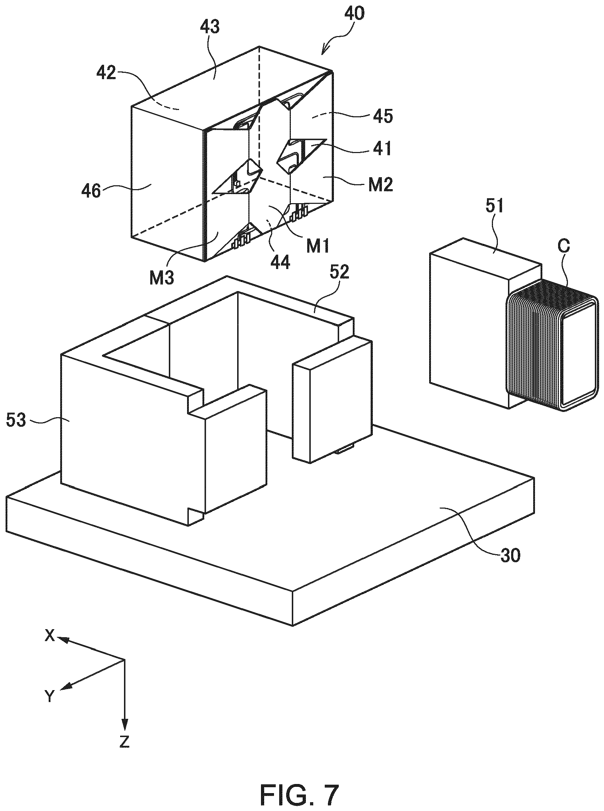

   FIG. 7 is a schematic exploded perspective view for explaining the structure of the sensor main body part 10.
[FIG. 8]

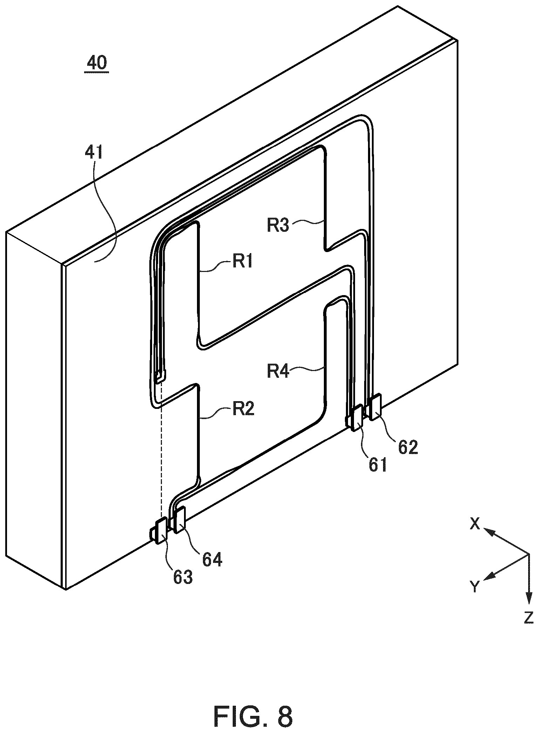

   FIG. 8 is a schematic perspective view illustrating a state where the magnetic yokes M1 to M3 are removed from the magnetic sensor 40.
[FIG. 9]

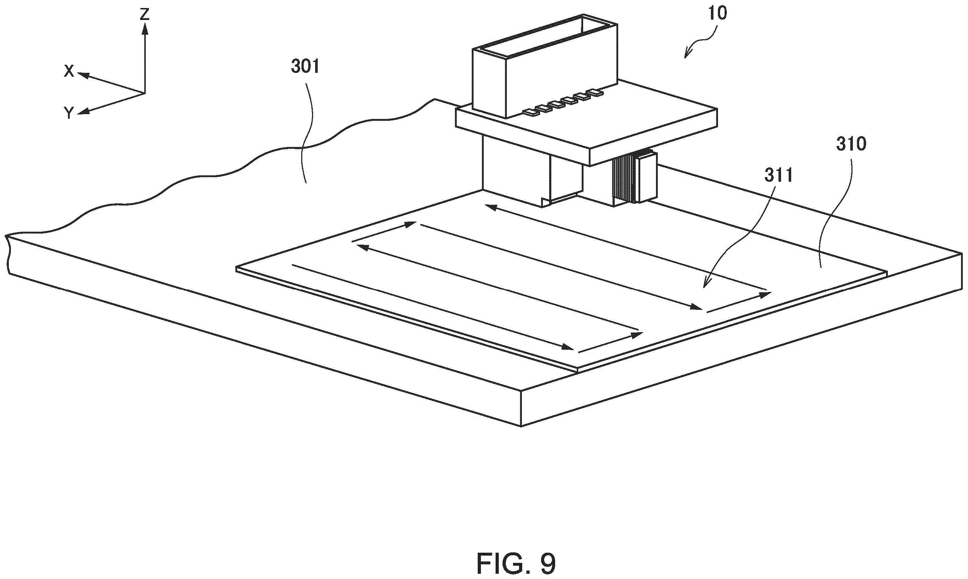

   FIG. 9 is a schematic diagram for explaining a method of scanning the sample 310 with the sensor body 10.
[FIG. 10]

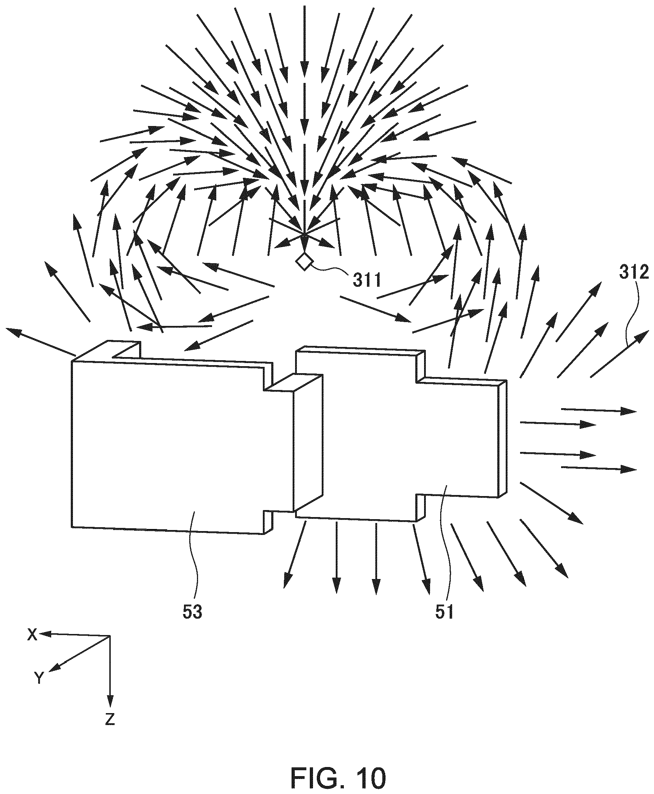

   FIG. 10 is a schematic diagram for explaining the magnetic field generated by the metallic foreign object 311.
[FIG. 11]

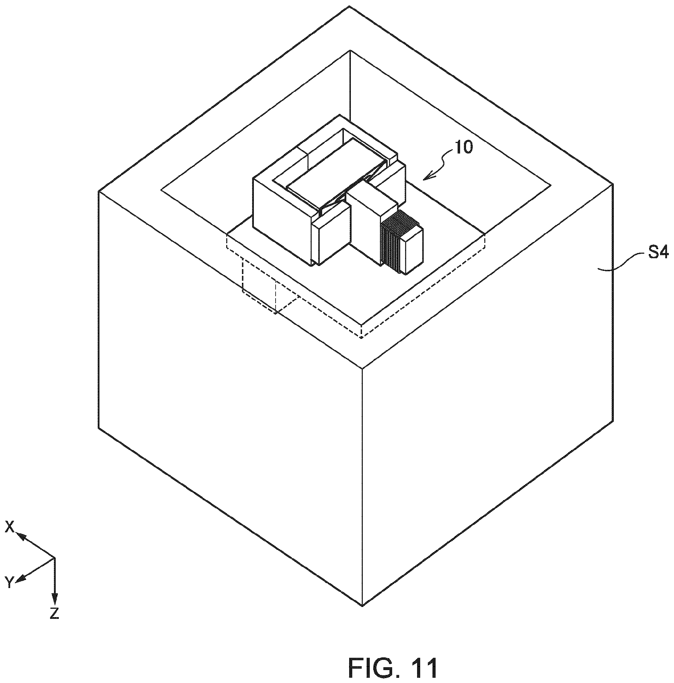

   FIG. 11 is a schematic perspective view illustrating an example in which the sensor main body part 10 is covered with another magnetic shield S4.
[FIG. 12]

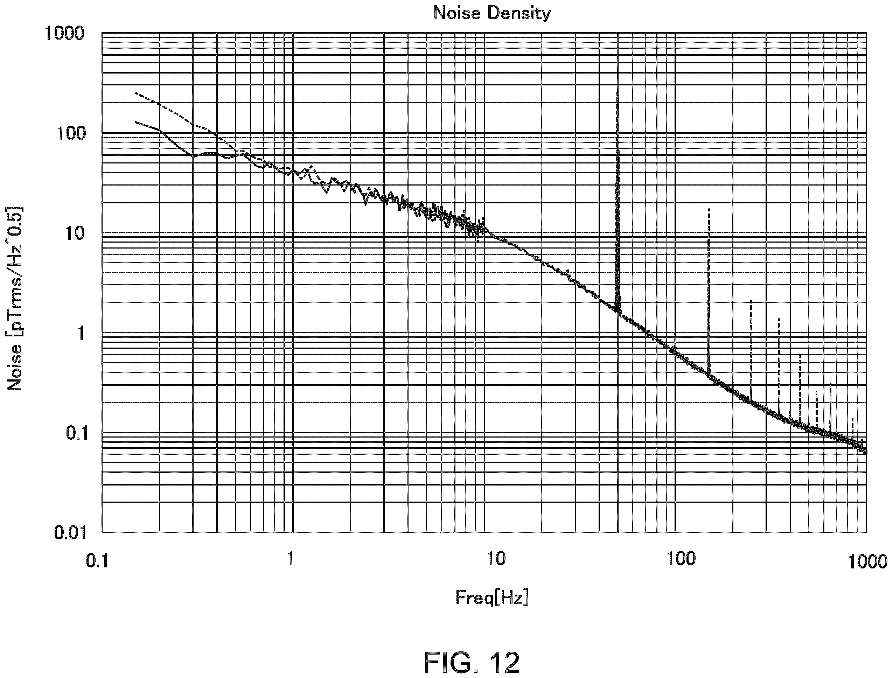

   FIG. 12 is a graph for explaining the effect of the magnetic shield S4.
[FIG. 13]

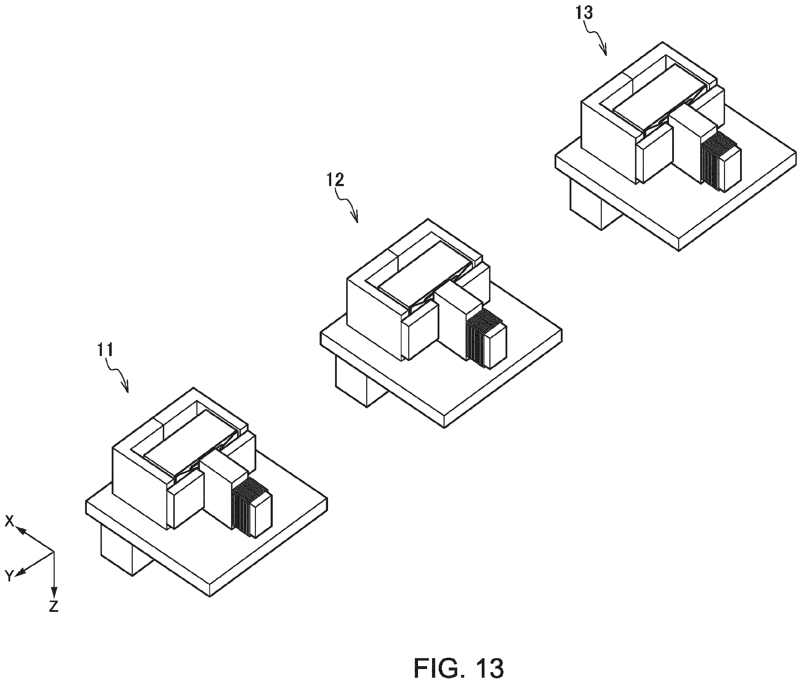

   FIG. 13 is a schematic perspective view illustrating a first example in which a plurality of sensor main body parts are provided in the measurement space 230.
[FIG. 14]

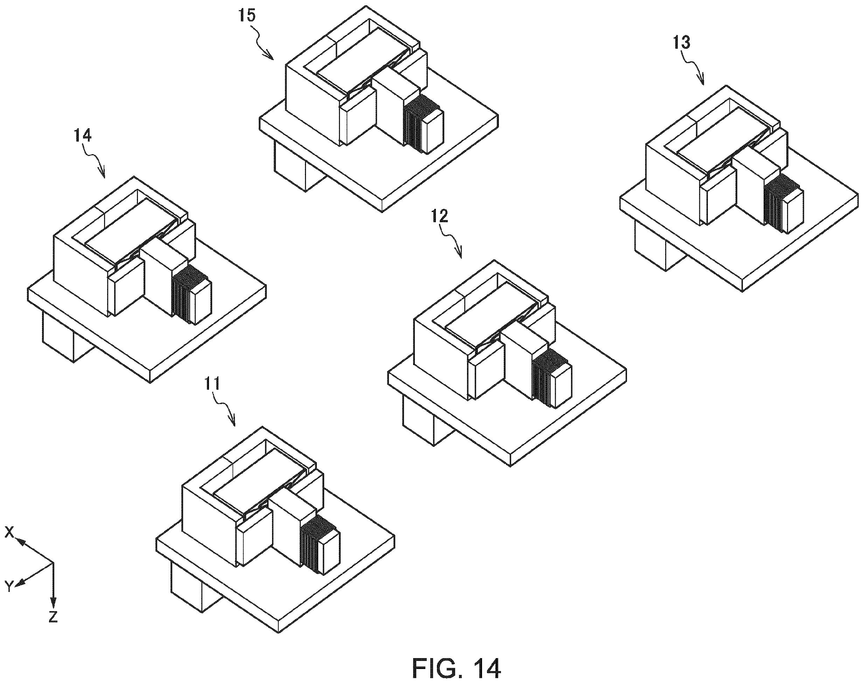

   FIG. 14 is a schematic perspective view illustrating a second example in which a plurality of sensor main body parts are provided in the measurement space 230.
[FIG. 15]

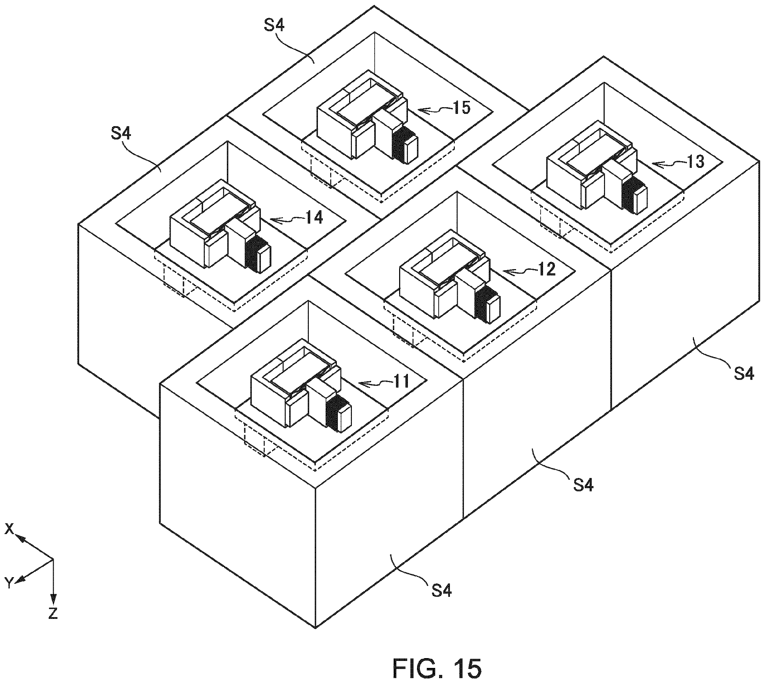

   FIG. 15 is a schematic perspective view illustrating an example in which the sensor main body parts 11 to 15 are each covered with the magnetic shield S4.

### [Mode for Carrying Out the Invention]

Hereinafter, preferred embodiments of the present invention will be described in detail with reference to the accompanying drawings.

FIG. 1 is a schematic perspective view illustrating the outer appearance of a magnetic field detection system 100 according to an embodiment of the present invention.

As illustrated in FIG. 1, the magnetic field detection system 100 according to the present embodiment has a frame 110, a shield box 200, and a sample stage 300. The shield box 200 and sample stage 300 are supported by the frame 110. The frame 110 has a guide 111 extending in the X-direction, a guide 113 extending in the Z-direction, and a movable beam 120 configured to be movable in the X-direction along the guide 111. The shield box 200 is connected to the guide 113, and the sample stage 300 is connected to the movable beam 120.

The movable beam 120 is movably configured in the X-direction by a drive mechanism 141 (e.g., a motor) . The movable beam 120 is provided with a guide 112 extending in the Y-direction, and the sample stage 300 is movably configured in the Y-direction along the guide 112. The Y-direction movement of the sample stage 300 along the guide 112 is achieved by a drive mechanism 142 (e.g., a motor). The shield box 200 is movably configured in the Z-direction along the guide 113. The Z-direction movement of the shield box 200 along the guide 113 is achieved by a drive mechanism (e.g., a motor). Thus, the relative positional relationship between the shield box 200 and sample stage 300 can be varied by the drive mechanisms 141 to 143.

FIGS. 2 and 3 are schematic perspective views for explaining the structure of the shield box 200 as viewed from mutually different directions.

As illustrated in FIGS. 2 and 3, the shield box 200 has a main body part 210 made of resin or the like and a connection part 220 connecting the main body part 210 to the guide 113. The main body part 210 is provided with magnetic shields S1 to S3 each made of a high permeability material such as permalloy. The magnetic shields S1 to S3 are arranged so as to surround a measurement space 230. Among them, the magnetic shield S1 is positioned at the innermost side, and the magnetic shield S3 is positioned at the outermost side. The main body part 210 includes a plurality of parts 211 to 214. The part 211 is positioned at the inner wall side of the magnetic shield S1, part 212 is positioned between the magnetic shields S1 and S2, part 213 is positioned between the magnetic shields S2 and S3, and part 214 is positioned at the outer wall side of the magnetic shield S3. The part 211 is fixed with a sensor holder 400 holding a sensor main body part 10, whereby the sensor main body part 10 is fixed to the shield box 200 in the measurement space 230.

The magnetic shield S1 is a cylindrical body covering the measurement space 230 from both sides in the Y-direction and both sides in the Z-direction and has a pair of flat parts constituting the XY plane and curved parts each connecting, in an arc, the pair of flat parts. The part 211 of the main body part 210 covers the inner wall of one flat part of the magnetic shield S1. The magnetic shield S2 is a plate-like body positioned outside the magnetic shield S1 and curved in a C-shape so as to cover the measurement space 230 from one side in the X-direction and both sides in the Z-direction. The magnetic shield S3 is a plate-like body positioned outside the magnetic shield S2 and curved in a C-shape so as to cover the measurement space 230 from both sides in the Y-direction and one side in the Z-direction. Like the magnetic shield S1, the magnetic shield S3 may be a cylindrical body covering the measurement space 230 from both sides in the Y-direction and both sides in the Z-direction.

Thus, the measurement space 230 is doubly or triply shielded in the Y- and Z-directions by the magnetic shields S1 to S3 and shielded in the X-direction by the magnetic shield S2. The other side of the measurement space 230 in the X-direction is opened, from which a part of the sample stage 300 is inserted into the measurement space 230.

FIG. 4 is a schematic perspective view for explaining the structure of the sample stage 300.

As illustrated in FIG. 4, the sample stage 300 has a table 301 on which a sample 310 to be inspected is placed and a connection part 302 connecting the table 301 and drive mechanism 142. The table 301 is a part to be inserted into the measurement space 230, and the surface thereof constitutes the XY plane. Although not particularly limited, the sample 310 has a plate-like shape in the example of FIG. 4.

FIG. 5 is a schematic perspective view for explaining the structure of the sensor holder 400.

The sensor holder 400 is a molding made of resin or the like and has, as illustrated in FIG. 5, a plate part 401 constituting the XY plane and a sensor housing part 402 protruding in the Z-direction from the plate part 401. The XY plane of the plate part 401 is fixed to the XY plane of the part 211 of the shield box 200. The sensor housing part 402 holds the sensor main body part 10 including a magnetic sensor.

FIGS. 6 and 7 are views for explaining the structure of the sensor main body part 10. FIG. 6 is a schematic perspective view, and FIG. 7 is a schematic exploded perspective view.

As illustrated in FIGS. 6 and 7, the sensor main body part 10 has, on the surface of a sensor substrate 30, a chip-like magnetic sensor 40 and magnetic field collecting bodies 51 to 53. The magnetic sensor 40 is formed into a substantially rectangular parallelepiped shape and has an element formation surface 41 and a back surface 42 which constitute the YZ plane, upper and lower surfaces 43 and 44 which constitute the XY plane, and side surfaces 45 and 46 which constitute the XZ plane. The element formation surface 41 is a surface on which a magnetosensitive element is formed. The magnetic sensor 40 is mounted on the sensor substrate 30 such that the lower surface 44 faces the sensor substrate 30 and that the element formation surface 41 is perpendicular to the surface of the sensor substrate 30. There are formed, on the element formation surface 41 of the magnetic sensor 40, magnetic yokes M1 to M3 made of permalloy or the like, and the magnetosensitive element is disposed near magnetic gaps formed between the magnetic yoke M1 and magnetic yokes M2, M3. With this configuration, magnetic flux passing through the magnetic gap is applied to the magnetosensitive element.

FIG. 8 is a schematic perspective view illustrating a state where the magnetic yokes M1 to M3 are removed from the magnetic sensor 40.

As illustrated in FIG. 8, magnetosensitive elements R1 to R4 are formed on the element formation surface 41 of the magnetic sensor 40. The magnetosensitive elements R1 to R4 have their magnetosensitive direction in the Y-direction. All the magnetosensitive elements R1 to R4 have magnetosensitive direction in the Y-direction. The magnetosensitive elements R1 and R2 are disposed near the magnetic gap formed between the magnetic yokes M1 and M2, and magnetosensitive elements R1 and R2 are disposed near the magnetic gap formed between the magnetic yokes M1 and M3. The magnetosensitive elements R1 to R4 are bridge-connected between terminal electrodes 61 and 62, and differential signals corresponding to a magnetic field appear at terminal electrodes 63 and 64.

The magnetic field collecting bodies 51 to 53 are blocks made of a magnetic material such as ferrite and act to collect a magnetic field emitted from the sample 310 in the magnetic sensor 40. The magnetic field collecting bodies 51 to 53 respectively overlap the magnetic yokes M1 to M3 in the X-direction. That is, the magnetic field collecting bodies 51 to 53 are arranged in the Y-direction on the element formation surface 41, the magnetosensitive elements R3 and R4 are disposed between the magnetic field collecting bodies 51 and 52 as viewed in the X-direction, and the magnetosensitive elements R1 and R2 are disposed between the magnetic field collecting bodies 51 and 53 as viewed in the X-direction.

The magnetic field collecting body 51 is elongated in the X-direction and acts to collect mainly a magnetic field in the X-direction in the magnetic yoke M1. The magnetic field collecting body 52 covers the side and back surfaces 45 and 42 of the magnetic sensor 40, and magnetic field collecting body 53 covers the side and back surfaces 46 and 42 of the magnetic sensor 40. With this configuration, the X-direction magnetic field collected by the magnetic field collecting body 51 is curved by the magnetic yoke M1 to flow to the magnetic field collecting bodies 52 and 53 through the magnetic yokes M2 and M3. As a result, the magnetic field passing through the magnetic gaps between the magnetic yoke M1 and magnetic yokes M2, M3 is detected by the magnetosensitive elements R1 to R4. In the example illustrated in FIGS. 6 and 7, a compensation coil C is wound around the magnetic field collecting body 51, in which a cancellation current flows to cancel the magnetic field to be applied to the magnetosensitive elements R1 to R4.

It is possible to bring the thus configured sensor main body part 10 close to the sample 310 placed on the surface of the table 301 by moving the shield box 200 in the Z-direction using the drive mechanism 143. The distance between the sample 310 and sensor main body part 10 in the Z-direction is preferably as small as possible within a range where they do not interfere with each other. After adjustment of the position of the sensor main body part 10 in the Z-direction by the use of the drive mechanism 143, as shown in FIG. 9, the sample stage 300 is shifted in the XY plane direction using the drive mechanisms 141 and 142 to allow the sensor main body part 10 to scan the sample 310. The sample 310 is previously applied with a magnetic field and thus, when a metal foreign object 311 such as iron (Fe) is mixed in the sample 310, it is possible to detect a magnetic field generated by the magnetized metal foreign object 311.

The metal foreign object 311 and sensor main body part 10 face each other in the Z-direction; however, when the sample 310 and sensor main body part 10 are brought close to each other sufficiently in the Z-direction, it is possible to collect the X-direction component of the magnetic field generated by the metal foreign object 311 using the magnetic field collecting bodies 51 to 53 and thus to apply it to the magnetosensitive elements R1 to R4, as illustrated in FIG. 10. In FIG. 10, a reference number 312 indicates the direction and strength of magnetic field generated by the metal foreign object 311. By thus setting the longitudinal direction (X-direction) of the magnetic field collecting body 51 perpendicular to the separating direction (Z-direction) between the sample 310 and sensor main body part 10, it is possible to further reduce the distance between the sample 310 and magnetosensitive elements R1 to R4 and to thereby achieve higher detection sensitivity.

As described above, the magnetic field detection system 100 according to the present embodiment is configured such that the magnetic sensor 40 scans the surface of the sample 310 in the XY plane direction, the number of magnetic sensors to be used can be reduced to one. This can not only lead to reduction in the cost of the magnetic sensor but also prevent occurrence of problems due to characteristic variations between a plurality of magnetic sensors. Further, the measurement space 230 in which the sample 310 and magnetic sensor 40 is triply shielded by the magnetic shields S1 to S3, so that influence of disturbance magnetic field emitted from the drive mechanisms 141 to 143 and the like is reduced. In particular, the YZ direction side (as viewed from the magnetic sensor 40) of the measurement space 230 at which the drive mechanisms 141 to 143 are disposed is doubly or triply shielded by the magnetic shields S1 to S3, making it possible to significantly reduce magnetic influence of the drive mechanisms 141 to 143.

In addition, the magnetic shields S1 to S3 each have an arc-like curved part and can thus achieve higher shield effect than when they each have a box-like shape constituted by a plate-like shape member. To achieve still higher shield effect, the magnetic shields S1 to S3 are each preferably formed into a circular shape as a whole; in this case, however, it becomes difficult to fix the magnetic sensor 40 in the measurement space 230. In the magnetic field detection system 100 according to the present embodiment, a part of each of the magnetic shields S1 to S3 is formed into a plate-like shape, and the remaining part thereof is into an arc-like shape, so that it is possible to easily fix the magnetic sensor 40 in the measurement space 230 while achieving high shield effect.

FIG. 11 is a schematic perspective view illustrating an example in which the sensor main body part 10 is covered with another magnetic shield S4.

The magnetic shield S4 illustrated in FIG. 11 is a cylindrical body which is fixed to the sensor holder 400 illustrated in FIGS. 2 and 5 to be disposed in the measurement space 230. The magnetic shield S4 may be made of a magnetic material such as ferrite. The magnetic shield S4 covers the sensor main body part 10 in the measurement space 230 from both sides in the X-direction and both sides in the Y-direction. When the sensor main body part 10 is covered with thus configured cylindrical magnetic shield S4, shield characteristics in the XY plane direction can be further enhanced, thus making it possible to further reduce magnetic influence of the drive mechanisms 141 to 143.

FIG. 12 is a graph for explaining the effect of the magnetic shield S4, in which the solid line indicates noise characteristics exhibited when the magnetic shield S4 is used, and the dashed line indicates noise characteristics exhibited when the magnetic shield S4 is not used. As can be seen from the graph of FIG. 12, influence of disturbance magnetic field that has not completely been eliminated only by the magnetic shields S1 to S3 is reduced by using the magnetic shield S4. Specifically, it can be seen that a 50Hz component as power supply noise is significantly reduced. It can be also seen that noise density in a low frequency region of 1 Hz or less is reduced.

FIG. 13 is a schematic perspective view illustrating a first example in which a plurality of sensor main body parts are provided in the measurement space 230.

In the example illustrated in FIG. 13, three sensor main body parts 11 to 13 are arranged in the Y-direction in the measurement space 230. The sensor main body parts 11 to 13 are the same in position in the X-direction. When a plurality of sensor main body parts are thus provided in the measurement space 230, the number of times of scanning operations described using FIG. 9 can be reduced, thereby improving measurement speed. When, for example, the three sensor main body parts 11 to 13 are provided as illustrated, the required number of times of scanning operations is reduced to one-third as compared with when one sensor main body parts 10 is used, and thus, the measurement speed is tripled. When a plurality of sensor main body parts are provided in the measurement space 230, the number and arrangement direction of the sensor main body parts are not particularly limited. However, when the arrangement direction of the senor main body parts is set to the X- or Y-direction, data processing is made easy.

FIG. 14 is a schematic perspective view illustrating a second example in which a plurality of sensor main body parts are provided in the measurement space 230.

In the example illustrated in FIG. 14, two sensor main body parts 14 and 15 are arranged in the Y-direction in the measurement space 230 in addition to the sensor main body parts 11 to 13. The sensor main body parts 14 and 15 are the same in position in the X-direction. The position of the sensor main body part 14 in the Y-direction is located between the sensor main body parts 11 and 12. The position of the sensor main body part 15 in the Y-direction is located between the sensor main body parts 12 and 13. When a plurality of senor main body parts are thus arranged in a staggered manner, it is possible to reduce scan pitch in the Y-direction while preventing interference between the plurality of sensor main body parts.

FIG. 15 is a schematic perspective view illustrating an example in which the sensor main body parts 11 to 15 are each covered with the magnetic shield S4.

As illustrated in FIG. 15, when the plurality of sensor main body parts 11 to 15 are each covered with the magnetic shield S4, a magnetic field from positions different from the scan position is shielded, thus enabling more correct measurement. Further, when a plurality of sensor main body parts are arranged in a staggered manner as illustrated in FIG. 15, it is possible to sufficiently ensure the thickness of the magnetic shield S4 while reducing scan pitch.

While the preferred embodiment of the present disclosure has been described, the present disclosure is not limited to the above embodiment, and various modifications may be made within the scope of the present disclosure, and all such modifications are included in the present disclosure.

### [Reference Signs List]

11-15 sensor main body part
30 sensor substrate
40 magnetic sensor
41 element formation surface
42 back surface
43 upper surface
44 lower surface
45, 46 side surface
51-53 magnetic field collecting body
61-64 terminal electrode
100 magnetic field detection system
110 frame
111-113 guide
120 movable beam
141-143 drive mechanism
200 shield box
210 main body part
211-214 part
220 connection part
230 measurement space
300 sample stage
301 table
302 connection part
310 sample
311 metal foreign object
312 magnetic field
400 sensor holder
401 plate part
402 sensor housing part
C compensation coil
M1-M3 magnetic yoke
R1-R4 magnetosensitive element
S1-S4 magnetic shield

## Claims

1. A magnetic field detection system comprising:
a shield box having a magnetic shield surrounding a measurement space;
a magnetic sensor fixed to the shield box in the measurement space;
a sample stage inserted at least at a part thereof into the measurement space; and
a drive mechanism for varying a relative positional relationship between the sample stage and shield box.

2. The magnetic field detection system as claimed in claim 1, wherein the drive mechanism includes a first drive mechanism for varying a relative positional relationship between the sample stage and the shield box in a first direction, a second drive mechanism for varying a relative positional relationship between the sample stage and the shield box in a second direction perpendicular to the first direction, and a third drive mechanism for varying a relative positional relationship between the sample stage and the shield box in a third direction perpendicular to the first and second directions.

3. The magnetic field detection system as claimed in claim 2,
wherein a surface of the sample stage on which a sample is placed extends in the first and second directions,
wherein the first and second drive mechanisms drive the sample stage, and
wherein the third drive mechanism drives the shield box.

4. The magnetic field detection system as claimed in claim 3, further comprising a magnetic field collecting element which is disposed on an element formation surface of the magnetic sensor that extends parallel to the third direction and which is elongated in a direction perpendicular to the element formation surface.

5. The magnetic field detection system as claimed in any one of claims 2 to 4,
wherein the magnetic shield includes a cylindrical first magnetic shield that covers the measurement space from both sides in the second direction and both sides in the third direction and a second magnetic shield that covers the measurement space from one side in the first direction, and
wherein the sample stage is inserted into the measurement space from another side in the first direction.

6. The magnetic field detection system as claimed in claim 5, wherein at least part of the first and second magnetic shields has an arc-like shape.

7. The magnetic field detection system as claimed in claim 5, further comprising a sensor holder that holds the magnetic sensor,
wherein the first magnetic shield has a flat part extending in the first and second directions,
wherein the shield box further has a part that covers an inner wall of the flat part of the first magnetic shield from the third direction, and
wherein the sensor holder is fixed to the part of the shield box.

8. The magnetic field detection system as claimed in claim 5, wherein the magnetic shield further includes a third magnetic shield that covers the first magnetic shield from the second and third directions.

9. The magnetic field detection system as claimed in any one of claims 2 to 4, further comprising a fourth magnetic shield that covers the magnetic sensor from the first and second directions in the measurement space.

10. The magnetic field detection system as claimed in claim 2,
wherein a plurality of the magnetic sensors are provided in the measurement space, and
wherein the plurality of the magnetic sensors include first and second magnetic sensors arranged in one of the first and second directions.

11. The magnetic field detection system as claimed in claim 10,
wherein the plurality of the magnetic sensors further include a third magnetic sensor,
wherein the third magnetic sensor is located between the first magnetic sensor and the second magnetic sensor in the one of the first and second directions and is located at a position different from the first and second magnetic sensors in other of the first and second directions.

12. The magnetic field detection system as claimed in claim 10 or 11, further comprising a plurality of fourth magnetic shields each covers an associated one of the plurality of magnetic sensors from the first and second directions in the measurement space.
